# EUROPÄISCHE PATENTSCHRIFT

(11) **EP 3 205 499 B1**
(45) Veröffentlichungstag und Bekanntmachung des Hinweises auf die Patenterteilung: **15.05.2019**
(21) Anmeldenummer: 16155066.0
(22) Anmeldetag: 10.02.2016
(51) Int. Cl.: B41C 1/02, B41C 1/18, G03F 7/20, G03F 7/24, B41C 1/00

(54) **VERFAHREN ZUM STRUKTURIEREN EINER OBERFLÄCHE EINER TIEFDRUCKFORM**
METHOD FOR STRUCTURING A SURFACE OF A GRAVURE FORM
PROCEDE DESTINE A STRUCTURER UNE SURFACE D'UN MOULE DE ROTOGRAVURE

(43) Veröffentlichungstag der Anmeldung: 16.08.2017
(73) Patentinhaber: AKK GmbH, 47809 Krefeld (DE)
(72) Erfinder: KESPER, Peter, 47800 Krefeld (DE)
(74) Vertreter: Cohausz & Florack

(56) Entgegenhaltungen:
- EP-A1- 1 040 916
- WO-A2-2009/091229
- JP-A- H06 179 257
- US-A1- 2004 216 627
- Sophie Matthews-Paul: "Print-heads and picolitres: the relevance of droplet sizes | Output", , 11. April 2011 (2011-04-11), XP055291437, Gefunden im Internet: URL:https://www.outputmagazine.com/print/t ech/print-heads-and-picolitres-the-relevan ce-of-droplet-sizes/ [gefunden am 2016-07-26]

## Beschreibung

Die Erfindung betrifft ein Verfahren zum Strukturieren einer Oberfläche einer Tiefdruckform. Weiter betrifft die Erfindung eine Tiefdruckform mit einer Oberfläche, welche zumindest teilweise mit einem erfindungsgemäßen Verfahren strukturiert wurde sowie die Verwendung einer Druckvorrichtung zum Aufdrucken einer Schablonenschicht auf eine Tiefdruckform.

Die Oberflächen von Tiefdruckformen werden mit Näpfchen zur Aufnahme von Tinte strukturiert. Beim Druckvorgang wird die Tinte auf die strukturierte Oberfläche der Tiefdruckform gebracht. Überschüssige Tinte wird mittels einer Abstreichvorrichtung, insbesondere einer Rakel, von der Oberfläche entfernt. Damit verbleibt die Tinte überwiegend nur in den Näpfchen. Durch Druck wird das durch die Tinte in den Näpfchen gebildete Druckbild direkt auf das zu bedruckende Material übertragen.

Dabei bestehen an die Strukturierung der Oberfläche einer Tiefdruckform spezifische Anforderungen. Durch das Verwenden einer Abstreichvorrichtung können die Näpfchen nicht beliebig groß ausgestaltet werden, da ansonsten beim Abstreichen auch Tinte aus den Näpfchen entfernt wird. Daher werden auch breitere zu bedruckende Flächen durch eine Vielzahl von Näpfchen mit zwischenliegenden Stegen gebildet, wobei die Stege für eine hohe Druckqualität sehr fein ausgestaltet werden müssen. Weiter kann es für die Farbgebung erforderlich sein, die Näpfchen mit verschiedenen Tiefen auszustatten, so dass je nach Tiefe mehr oder weniger Tinte von dem jeweiligen Näpfchen aufgenommen wird. Schließlich ist die Oberfläche der Tiefdruckform durch den Druckvorgang und insbesondere das Abstreichen der Tinte einem Verschleiß ausgesetzt.

Zur Strukturierung der Oberfläche einer Tiefdruckform sind verschiedene Verfahren bekannt. Einerseits können ätztechnische Methoden verwendet werden. Hierbei wird zunächst eine flächendeckende Schablonenschicht aus einem fotosensitiven Material auf die Oberfläche aufgebracht. Die Schablonenschicht wird selektiv belichtet, womit die Löslichkeit der belichteten Bereiche der Schablonenschicht verändert wird. Durch die anschließende Ablösung von Teilbereichen der Schablonenschicht mit einem Lösemittel wird die Schablonenschicht strukturiert. Eine ätztechnische Behandlung der Oberfläche wird vorgenommen, mit welcher die Teilbereiche der Tiefdruckform, welche nicht von der Schablone abgedeckt werden, selektiv geätzt werden. Entsprechende ätztechnische Methoden sind jedoch oft nicht für hohe Prozessgeschwindigkeiten geeignet und im Hinblick auf die erforderliche feine Strukturierung der Oberfläche zu ungenau.

Zur Steigerung der Prozessgeschwindigkeit kann alternativ die Oberfläche mechanisch bearbeitet werden, wobei die Näpfchen durch eine mechanische Gravur mittels eines Stichels eingebracht werden. Eine elektromechanische Gravur kann beispielsweise auf Grundlage einer Vorlage, die gleichzeitig abgetastet wird, oder auch computerbasiert ausgeführt werden. Ebenso ist es bekannt, eine Struktur der Oberfläche einer Tiefdruckform mittels einer Lasergravur einzubringen. Entsprechende Vorrichtungen für elektromechanische oder lasertechnische Gravuren sind jedoch aufwändig und kostenintensiv.

Nach der Gravur wird die Oberfläche der Tiefdruckform üblicherweise verchromt. Die Chromschicht erhöht die Härte und Lebensdauer der Oberfläche. Jedoch ist das Verchromen aufgrund der damit verbundenen Sicherheitserfordernisse aufwändig und wenig umweltfreundlich.

Die EP 1 040 916 A1 beschreibt ein Verfahren und eine Vorrichtung zum Herstellen eines Druckwerkzeugs, bei welchem eine Maske aus Wachs über ein Druckverfahren aufgebracht wird.

In der JP H06-179257 A wird eine Tiefdruckform offenbart, welche über eine stromlose Plattierung insbesondere mit NiP beschichtet und über eine fotosensitive Schablone strukturiert wird.

Die US 2004/0216627 A1 betrifft ein Verfahren zum Herstellen einer Tiefdruckform. Eine Schicht mit UV-aushärtbaren Materialien wird auf eine metallische Oberfläche gebracht und mit einer Schablone teilweise abgedeckt. Die Schicht wird belichtet, selektiv entfernt und anschließend Metall auf die Oberfläche aufgebracht.

Die WO 2009/091229 A2 offenbart ein weiteres Verfahren zur Herstellung einer Tiefdruckform. Ein Glassubstrat wird mit Kupfer beschichtet, eine Schablone aus fotosensitivem Material aufgebracht und eine Plattierung mit Nickel vorgenommen.

Ausgehend von diesem Stand der Technik liegt der Erfindung liegt die Aufgabe zugrunde, ein Verfahren zum Strukturieren einer Oberfläche einer Tiefdruckform vorzuschlagen, mit welchem eine präzise Strukturierung mit geringem apparativen Aufwand erreicht wird. Weiter soll eine Tiefdruckform sowie die Verwendung einer Druckvorrichtung angegeben werden.

Gemäß der ersten Lehre der Erfindung wird ein Verfahren zum Strukturieren einer Oberfläche einer Tiefdruckform angegeben, bei dem eine Schablonenschicht auf die Oberfläche der Tiefdruckform aufgedruckt wird, wobei das Aufdrucken durch Aufjetten von Schablonenmaterial in Form von Tröpfchen durchgeführt wird, wobei zumindest teilweise ein Tröpfchenvolumen von weniger als 10 pl verwendet wird, wobei die Schablonenschicht beim Aufdrucken konturiert wird, so dass die Schablonenschicht Ausnehmungen aufweist, bei dem eine chemische Behandlung der Oberfläche der Tiefdruckform nach dem Aufdrucken der Schablonenschicht vorgenommen wird, wobei Material auf die Oberfläche der Tiefdruckform aufgebracht oder von der Oberfläche der Tiefdruckform entfernt wird.

Es hat sich herausgestellt, dass ein Tröpfchenvolumen von weniger als 80 pl ausreicht, die für die Strukturierung einer Tiefdruckform erforderlichen feinen Strukturen, beispielsweise von den Stegen zwischen den Näpfchen, herzustellen. Durch die Verwendung eines Tröpfchenvolumens von weniger als 80 pl können insbesondere Strukturen aufgedruckt werden, welche kleiner als 40 µm sind, d.h. ein einzelner Druckpunkt (Dot) kann einen Durchmesser von unterhalb 40 µm erreichen. Diese Größenordnung ermöglicht bereits eine hohe Druckqualität im Tiefdruck und insbesondere eine feine Strukturierung der Stege zwischen den Näpfchen.

Im Gegensatz zu den ätztechnischen Verfahren aus dem Stand der Technik, welche noch eine Belichtung und Ablösung von Teilbereichen einer Schablonenschicht benötigen, wird hier die Schablonenschicht beim Aufdrucken bereits konturiert und mit Ausnehmungen versehen. Dadurch kann die Schablonenschicht mit dem Aufdrucken bereits die endgültige Konturierung erhalten. Die Tiefdruckform kann direkt nach dem Aufdrucken der Schablonenschicht der chemischen Behandlung zugeführt werden, ohne dass weitere Schritte zur Konturierung der Schablone anfallen. Dadurch wird die Strukturierung der Oberfläche vereinfacht und die Prozessgeschwindigkeit erhöht.

Die chemische Behandlung der Oberfläche der Tiefdruckform bewirkt das Aufbringen oder Entfernen von Material an der Oberfläche der Tiefdruckform. Material wird insbesondere im Bereich der Ausnehmungen auf die Oberfläche der Tiefdruckform aufgebracht oder im Bereich der Ausnehmungen von der Oberfläche der Tiefdruckform entfernt.

Wird Material durch eine chemische Behandlung nach dem Aufdrucken der Schablonenschicht aufgebracht, so ergeben sich im Bereich der Ausnehmungen der Schablonenschicht Aufdickungen der Oberfläche der Tiefdruckform. Wird Material durch eine chemische Behandlung nach dem Aufdrucken der Schablonenschicht entfernt, entstehen Vertiefungen der Oberfläche der Tiefdruckform im Bereich der Ausnehmungen der Schablonenschicht. Entsprechend kann die Schablonenschicht als Negativform oder Positivform für die Struktur der Oberfläche dienen.

Die Schablonenschicht kann während der chemischen Behandlung oder nach der chemischen Behandlung in einem zusätzlichen Schritt entfernt werden, so dass die strukturierte Oberfläche der Tiefdruckfom freigelegt wird.

Die Tiefdruckform kann als Walze oder Walzenmantel ausgestaltet sein. Üblicherweise bestehen Walzen für Tiefdruckformen aus Stahl oder einer Stahllegierung, wobei insbesondere Kupfer als Material für die Oberfläche der Walze bzw. den Walzenmantel verwendet wird.

Tröpfchenvolumen von weniger als 10 pl werden verwendet. Damit kann die Größe der Strukturen auf weniger als 20 µm, insbesondere weniger als 10 µm verringert werden. Damit können die Stege zwischen den Näpfchen entsprechend fein strukturiert werden und die Druckqualität wird weiter gesteigert.

Es können für das Aufdrucken einer Schablonenschicht verschiedene Tröpfchenvolumina eingesetzt werden, wobei für große zu bedruckende Flächen größere Tröpfchenvolumina und für feinere Strukturen entsprechende geringe Tröpfchenvolumina verwendet werden. Dadurch kann die Druckgeschwindigkeit erhöht werden.

Eine weitere Ausgestaltung erfährt das zuvor beschriebene Verfahren dadurch, dass das aufgebrachte oder entfernte Material der Oberfläche der Tiefdruckform Nickel oder Nickelverbindungen aufweist. Damit kann eine erhöhte Verschleißfestigkeit der Oberfläche erreicht werden, ohne dass auf eine aufwändigere Verchromung zurückgegriffen werden muss. Insbesondere weist das aufgebrachte oder entfernte Material der Oberfläche der Tiefdruckform mindestens 50 Gew.-%, bevorzugt mindestens 75 Gew.-%, weiter bevorzugt mindestens 90 Gew.-% Nickel oder Nickelverbindungen auf.

Die Verwendung von Nickel oder Nickelverbindungen in dem aufzubringenden oder zu entfernenden Material hat sich in Verbindung mit dem Aufdrucken der Schablone durch Aufjetten von Tröpfchen als vorteilhaft für die Druckqualität herausgestellt.

Eine weitere Ausgestaltung erfährt das zuvor beschriebene Verfahren dadurch, dass die Schablonenschicht aufgedruckt wird und nach dem Aufdrucken eine chemische Behandlung umfassend eine Vernickelung vorgenommen wird. Mit einer Vernickelung wird Material in den Bereichen der Ausnehmung der Schablonenschichten auf die Oberfläche der Tiefdruckform gebracht.

Das Vernickeln kann durch eine chemische Deposition von Nickel oder Nickelverbindungen auf die Oberfläche erfolgen. In einer Ausgestaltung des zuvor beschriebenen Verfahrens wird als Schablonenmaterial ein elektrisch isolierendes Material verwendet und eine elektrochemische Vernickelung der Oberfläche vorgenommen. Eine elektrochemische Vernickelung bietet eine hohe Oberflächenqualität in Bezug auf einen Verschleiß beim Druckvorgang. Durch die elektrisch isolierenden Eigenschaften des Schablonenmaterials wird zudem bei einem elektrochemischen Vernickeln auf der Schablone im Wesentlichen kein Material aufgebracht, so dass ein hoher Kontrast in der Oberflächenstruktur entsteht, welcher sich wiederum positiv auf die Druckqualität auswirkt.

Eine alternative Ausgestaltung erfährt das Verfahren dadurch, dass die Oberfläche vor dem Aufdrucken der Schablonenschicht zumindest teilweise eine Vernickelung aufweist, als Schablonenmaterial ein ätzresistives Material verwendet wird und eine chemische Behandlung umfassend eine ätztechnische Oberflächenabtragung vorgenommen wird. Damit wird die Oberfläche im Wesentlichen im Bereich der Ausnehmungen der Schablonenschicht mit geätzten Vertiefungen strukturiert. Dabei entfallen die Schritte einer Belichtung und selektiven Ablösung einer fotosensitiven Schablonenschicht, da die Schablonenschicht bereits konturiert aufgedruckt werden kann. Über die ätztechnische Oberflächenabtragung lässt sich die Tiefe der eingebrachten Näpfchen kontrollieren. Beispielsweise kann die Vernickelung auf der Oberfläche eine definierte Dicke aufweisen, so dass über die Einstellung einer bestimmten Ätztiefe die Näpfchen in der vernickelten Oberflächenschicht liegen oder in das darunter liegende Material der Tiefdruckform reichen.

Eine nächste Ausgestaltung erfährt das Verfahren dadurch, dass als Schablonenmaterial ein Wachs, eine UV-härtbare Tinte oder eine Kombination hiervon verwendet wird. Mit Wachs oder einer UV-härtbare Tinte können mit den zuvor angegebenen Tröpfchengrößen prozesssicher kleine Druckpunkte bereitgestellt werden und somit eine hohe Druckqualität gewährleistet werden. Besonders eine Kombination von Wachs und UV-härtbarer Tinte hat sich für die Herstellung der Schablonenschicht als vorteilhaft herausgestellt.

Eine weitere Ausgestaltung erfährt das Verfahren dadurch, dass mindestens zwei Schablonenschichten aufgedruckt werden. Durch die Verwendung von mehreren Schablonenschichten, insbesondere in Kombinationen mit mehreren chemischen Behandlungen, kann der Oberfläche der Tiefdruckform auf einfache Weise eine Strukturierung mit verschiedenen Tiefen verliehen werden, beispielsweise mit unterschiedlich tiefen Näpfchen für eine Farbgebung.

Insbesondere werden zum Aufdrucken der mindestens zwei Schablonenschichten mindestens zwei verschiedene Schablonenmaterialien verwendet. Die verschiedenen Schablonenmaterialien können selektiv von der Oberfläche entfernbar sein, so dass beispielsweise ein chemische Behandlung der Oberfläche mit mehreren an der Oberfläche befindlichen Schablonenschichten durchgeführt und anschließend eine der Schablonenschichten abgelöst wird. Anschließend kann eine weitere chemische Behandlung der Oberfläche vorgenommen werden.

Schließlich erhält das Verfahren eine nächste Ausgestaltung dadurch, dass die Schablonenschicht zumindest teilweise in einem Hot-Melt-Verfahren aufgedruckt wird. Bei einem Hot-Melt-Verfahren wird das aufzudruckende Schablonenmaterial in einem Druckkopf erhitzt und verflüssigt, beispielsweise in einem Temperaturbereich von 60 °C bis 120 °C. Tröpfchen des verflüssigten Schablonenmaterials werden dann auf die Oberfläche der Tiefdruckwalze gejettet. Die Tröpfchen kühlen hierbei schon während des Fluges auf die Oberfläche sowie beim Auftreffen ab, so dass das Schablonenmaterial auf der Oberfläche der Tiefdruckwalze erstarrt.

Gemäß einer weiteren Lehre der Erfindung wird die oben genannte Aufgabe betreffend eine Tiefdruckform mit einer Oberfläche, welche Näpfchen und Stege zur Aufnahme von Tinte in einem Tiefdruckverfahren aufweist, dadurch gelöst, dass die Oberfläche zumindest teilweise mit einem zuvor beschriebenen Verfahren strukturiert wurde und die Stege zumindest teilweise eine minimale Abmessung von weniger als 20 µm aufweisen.

Durch die chemische Behandlung der Oberfläche weist die Tiefdruckform eine Struktur auf, welche mit einer mechanischen oder lasertechnischen Gravur nicht zu erreichen ist. Insbesondere die Form der Näpfchen unterscheidet sich hierbei. Das zuvor beschriebene Verfahren zum Strukturieren einer Oberfläche einer Tiefdruckform erlaubt insbesondere eine flexible Variation der Form der Näpfchen auf der Oberfläche.

Wird die Schablonenschicht aufgedruckt und nach dem Aufdrucken eine chemische Behandlung umfassend eine Vernickelung vorgenommen, erhält die Tiefdruckform eine Struktur, welche sich wesentlich von der Struktur einer mechanischen oder lasertechnischen Gravur als auch der Struktur eines ätztechnischen Verfahrens mit einer fotosensitiven Schablonenschicht unterscheidet, da bei der Vernickelung Material aufgebracht und nicht entfernt wird. Somit ist es möglich, den Näpfchen eine andere Form zu verleihen als mit den aus dem Stand der Technik bekannten Verfahren.

Durch das zuvor beschriebene Verfahren zum Strukturieren einer Oberfläche einer Tiefdruckform kann die Oberfläche auf eine flexiblere Weise ausgestaltet werden. Die Stege weisen zumindest teilweise eine minimale Abmessung von weniger als 20 µm auf.

Eine Ausgestaltung erhält die Tiefdruckform dadurch, dass diese als Walze oder Walzenmantel ausgestaltet ist. Üblicherweise bestehen Walzen für Tiefdruckformen aus Stahl oder einer Stahllegierung, wobei insbesondere Kupfer als Material für die Oberfläche der Walze bzw. den Walzenmantel verwendet wird.

Gemäß einer weiteren Lehre der Erfindung wird die oben genannte Aufgabe betreffend eine Verwendung einer Druckvorrichtung zum Aufdrucken einer Schablonenschicht auf eine Tiefdruckform dadurch gelöst, dass das Aufdrucken durch Aufjetten von Schablonenmaterial in Form von Tröpfchen durchgeführt wird und ein Tröpfchenvolumen von zumindest teilweise weniger als 10 pl verwendet wird.

Insbesondere wird die Schablonenschicht auf eine Oberfläche der Tiefdruckform aufgedruckt, welche Nickel oder eine Nickelverbindung aufweist.

Es gibt nun eine Vielzahl von Möglichkeiten, die erfindungsgemäßen Lehren auszugestalten und weiterzubilden. Zu weiteren Ausgestaltungen des Verfahrens, der Tiefdruckform und der Verwendung wird auch auf die Ausführungen zu den jeweiligen anderen Lehren verwiesen. Weiterhin wird beispielhaft verwiesen auf die nachfolgende Beschreibung von Ausführungsbeispielen in Verbindung mit der Zeichnung. In der Zeichnung zeigt
- Fig. 1: eine schematische Ansicht einer strukturierten Oberfläche einer Tiefdruckform,
- Fig. 2: eine schematische Ansicht des Verfahrens zum Strukturieren einer Oberfläche bzw. der Verwendung einer Druckvorrichtung,
- Fig. 3a-c: schematische Ansichten eines ersten Ausführungsbeispiels des Verfahrens und
- Fig. 4a-d: schematische Ansichten eines zweiten Ausführungsbeispiels des Verfahrens.

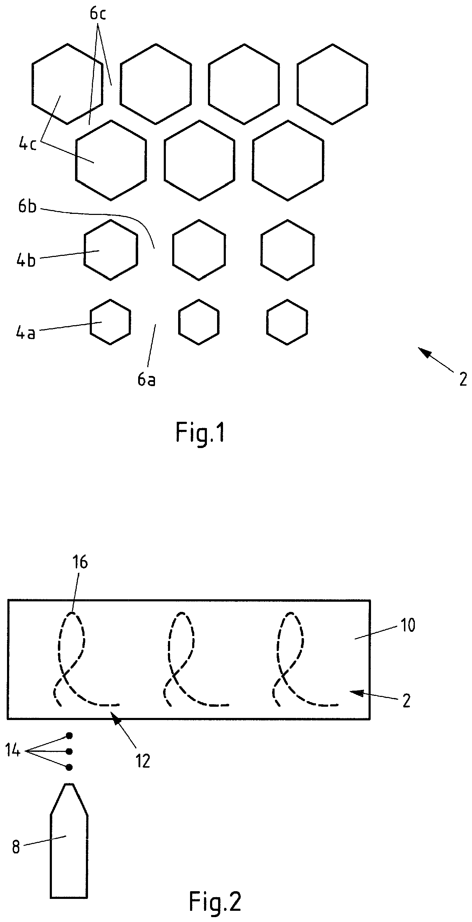

Fig. 1 zeigt eine schematische Ansicht einer strukturierten Oberfläche 2 einer Tiefdruckform. An der Oberfläche 2 befinden sich Näpfchen 4a, 4b, 4c, welche durch Vertiefungen gebildet werden und zur Aufnahme von Tinte ausgestaltet sind. Fig. 1 zeigt beispielhaft die Ausgestaltung der Näpfchen 4a, 4b, 4c in einer Sechseckform, wobei auch andere Formen oder auch eine Variation der Form über die Oberfläche 2 möglich sind. Dargestellt sind verschiedene Größen der Näpfchen 4a, 4b, 4c zur Farbgebung, wobei die Näpfchen 4a, 4b, 4c auch alternativ oder kumulativ verschiedene Tiefen aufweisen können.

Zwischen den Näpfchen 4a, 4b, 4c befinden sich Stege 6a, 6b, 6c, welche mittels einer Rakel (nicht gezeigt) abgestrichen werden können, so dass auf den Stegen 6a, 6b, 6c im Wesentlichen keine Tinte verbleibt. Die Näpfchen 4a, 4b, 4c können aufgrund des Abstreichens nicht beliebig groß gestaltet werden. Auch in Bereichen, in welchen ein flächendeckendes Druckbild erreicht werden soll, können Stege 6a, 6b, 6c vorgesehen sein, welche jedoch entsprechend fein ausgestaltet sein müssen. Die Breiten für die Stege 6a, 6b, 6c können für eine hohe Druckqualität unterhalb 20 µm oder sogar unterhalb 10 µm betragen.

Fig. 2 zeigt eine schematische Ansicht des Verfahrens zum Strukturieren einer Oberfläche 2 bzw. der Verwendung einer Druckvorrichtung 8, welche beispielsweise mit einem Hot-Melt-Verfahren arbeitet. Eine Tiefdruckform 10, deren Oberfläche 2 strukturiert werden soll, wird über die Druckvorrichtung 8 selektiv mit einer Schablonenschicht 12 bedruckt. Hierzu wird Schablonenmaterial in Form von Tröpfchen 14 aufgejettet. Zumindest teilweise wird ein Tröpfchenvolumen von weniger als 10 pl verwendet. Die Schablonenschicht 12 wird beim Aufdrucken bereits konturiert, so dass die Schablonenschicht Ausnehmungen 16 aufweist.

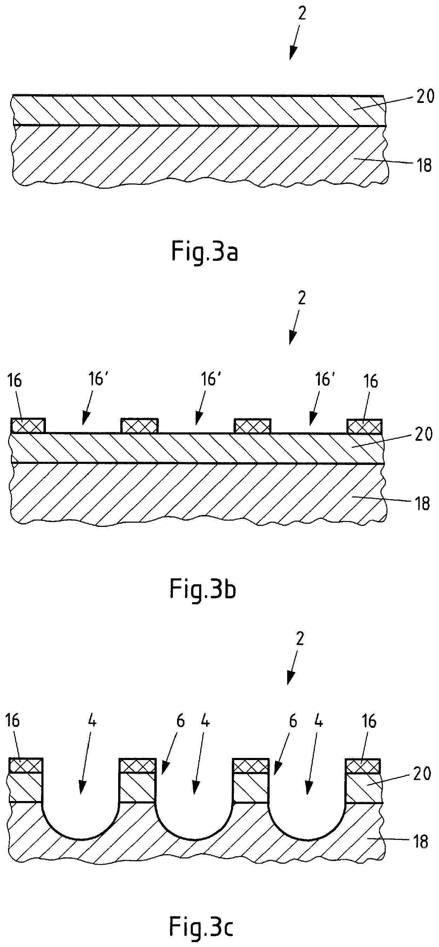

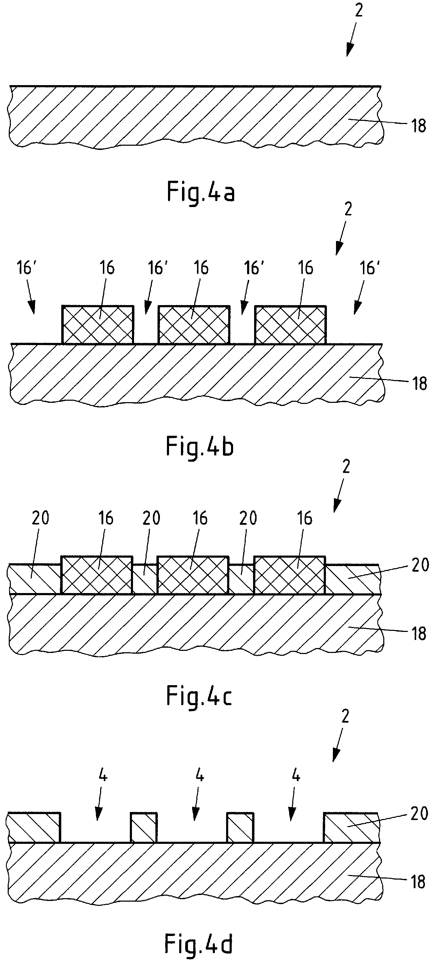

Mit einer chemischen Behandlung der Oberfläche 2 der Tiefdruckform 10 wird Material auf die Oberfläche 2 der Tiefdruckform 10 aufgebracht oder von der Oberfläche 2 der Tiefdruckform 10 entfernt. Hierzu zeigen die Fig. 3a-c und Fig. 4a-d jeweils ein Ausführungsbeispiel des Verfahrens.

In Fig. 3a ist eine Oberfläche 2 einer Tiefdruckform schematisch dargestellt. Auf einer inneren Schicht 18 ist eine äußere Schicht 20 angeordnet. Die Schichten 18, 20 können aus verschiedenen Materialien bestehen, beispielsweise umfasst die innere Schicht 18 im Wesentlichen Kupfer oder eine Kupferlegierung und die äußere Schicht 20 umfasst Nickel oder eine Nickelverbindung. Insbesondere wird die äußere Schicht durch eine Vernickelung aufgebracht und/oder weist mindestens 50 Gew.-%, bevorzugt mindestens 75 Gew.-%, weiter bevorzugt mindestens 90 Gew.-% Nickel oder Nickelverbindungen auf.

Auf die Oberfläche 2 wird durch Aufjetten von Tröpfchen eine strukturierte Schablonenschicht 16 gedruckt, wobei bereits mit dem Aufdrucken Ausnehmungen 16' in der Schablonenschicht gebildet werden, wie in Fig. 3b wiedergegeben. Ein Tröpfchenvolumen von weniger als 80 pl erlaubt insbesondere das Aufdrucken von Strukturen, welche kleiner als 40 µm sind, d.h. ein einzelner Druckpunkt (Dot) kann einen Durchmesser von unterhalb 40 µm erreichen. Insbesondere können mit Tröpfchenvolumen von weniger als 30 pl Strukturen aufgedruckt werden, welche kleiner als 25 µm sind. Weiter können Tröpfchenvolumen von weniger als 10 pl verwendet werden. Damit kann die Größe der Strukturen auf weniger als 20 µm, insbesondere weniger als 10 µm verringert werden.

Durch eine chemische Behandlung, beispielsweise durch eine ätztechnische Behandlung, wird nun wie in Fig. 3c gezeigt Material von der Oberfläche 2 entfernt. Insbesondere in den Bereichen der Ausnehmungen 16' werden damit Näpfchen 4 in die Oberfläche 2 eingebracht. Die Stege 6 zwischen den Näpfchen 4 können mit den geringen Tröpfchenvolumina entsprechend fein strukturiert werden. Die Stege 6 können zumindest teilweise eine minimale Abmessung von weniger als 40 µm, insbesondere von weniger als 20 µm aufweisen.

Fig. 4a-d zeigt ein weiteres Ausführungsbeispiel des Verfahrens zum Strukturieren einer Oberfläche 2 einer Tiefdruckform. Fig. 4a zeigt zunächst die Oberfläche 2 vor dem Bedrucken, wobei die Oberfläche von einer inneren Schicht 18 gebildet wird, welche beispielsweise im Wesentlichen Kupfer oder eine Kupferlegierung umfasst.

Wie in Fig. 4b gezeigt, wird auf die Oberfläche 2 eine strukturierte Schablonenschicht 16 gedruckt, wobei bereits mit dem Aufdrucken Ausnehmungen 16' in der Schablonenschicht gebildet werden.

Anschließend wird, wie in Fig. 4c dargestellt, eine chemische Behandlung der Oberfläche 2 der Tiefdruckform vorgenommen, wobei Material auf die Oberfläche 2 der Tiefdruckform aufgebracht wird. Insbesondere wird als Schablonenmaterial ein elektrisch isolierendes Material verwendet, beispielsweise ein Wachs, eine UV-härtbare Tinte oder eine Kombination hiervon, und eine elektrochemische Vernickelung der Oberfläche 2 vorgenommen. Durch die elektrisch isolierenden Eigenschaften der Schablonenschicht 16 wird lediglich in dem Bereich der Ausnehmungen 16' eine äußere Schicht 20 aufgebracht, welche mit der Schablonenschicht 16 strukturiert wird.

Die Schablonenschicht 16 kann anschließend entfernt werden, beispielsweise über ein Lösungsmittel. Dann verbleibt, wie in Fig. 4d gezeigt, die strukturierte Oberfläche 2 mit Näpfchen 4 als Ausnehmungen in der äußeren Schicht 20.

## Patentansprüche

1. Verfahren zum Strukturieren einer Oberfläche einer Tiefdruckform,
- bei dem eine Schablonenschicht auf die Oberfläche der Tiefdruckform aufgedruckt wird,
- wobei das Aufdrucken durch Aufjetten von Schablonenmaterial in Form von Tröpfchen durchgeführt wird,
- wobei die Schablonenschicht beim Aufdrucken konturiert wird, so dass die Schablonenschicht Ausnehmungen aufweist, und
- bei dem eine chemische Behandlung der Oberfläche der Tiefdruckform nach dem Aufdrucken der Schablonenschicht vorgenommen wird, wobei Material auf die Oberfläche der Tiefdruckform aufgebracht oder von der Oberfläche der Tiefdruckform entfernt wird, **dadurch gekennzeichnet, dass** zumindest teilweise ein Tröpfchenvolumen von weniger als 10 pl verwendet wird.

2. Verfahren nach Anspruch 1,
**dadurch gekennzeichnet, dass**
das aufgebrachte oder entfernte Material der Oberfläche der Tiefdruckform Nickel oder Nickelverbindungen aufweist.

3. Verfahren nach Anspruch 1 oder 2,
**dadurch gekennzeichnet, dass**
die Schablonenschicht aufgedruckt wird und nach dem Aufdrucken eine chemische Behandlung umfassend eine Vernickelung vorgenommen wird.

4. Verfahren nach Anspruch 3,
**dadurch gekennzeichnet, dass**
als Schablonenmaterial ein elektrisch isolierendes Material verwendet wird und eine elektrochemische Vernickelung der Oberfläche vorgenommen wird.

5. Verfahren nach Anspruch 1 oder 2,
**dadurch gekennzeichnet, dass**
- die Oberfläche vor dem Aufdrucken der Schablonenschicht zumindest teilweise eine Vernickelung aufweist,
- als Schablonenmaterial ein ätzresistives Material verwendet wird und
- eine chemische Behandlung umfassend eine ätztechnische Oberflächenabtragung vorgenommen wird.

6. Verfahren nach einem der Ansprüche 1 bis 5,
**dadurch gekennzeichnet, dass**
als Schablonenmaterial ein Wachs, eine UV-härtbare Tinte oder eine Kombination hiervon verwendet wird.

7. Verfahren nach einem der Ansprüche 1 bis 6,
**dadurch gekennzeichnet, dass**
mindestens zwei Schablonenschichten aufgedruckt werden.

8. Verfahren nach einem der Ansprüche 1 bis 7,
**dadurch gekennzeichnet, dass**
zum Aufdrucken der mindestens zwei Schablonenschichten mindestens zwei verschiedene Schablonenmaterialien verwendet werden.

9. Verfahren nach einem der Ansprüche 1 bis 8,
**dadurch gekennzeichnet, dass**
die Schablonenschicht zumindest teilweise in einem Hot-Melt-Verfahren aufgedruckt wird.

10. Tiefdruckform (10), mit einer Oberfläche (2), welche Näpfchen (4; 4a, 4b, 4c) und Stege(6; 6a, 6b, 6c) zur Aufnahme von Tinte in einem Tiefdruckverfahren aufweist,
**dadurch gekennzeichnet, dass**
die Oberfläche (2) zumindest teilweise mit einem Verfahren nach einem der Ansprüche 1 bis 9 strukturiert wurde und
die Stege (6; 6a, 6b, 6c) zumindest teilweise eine minimale Abmessung von weniger als 20 µm aufweisen.

11. Tiefdruckform nach Anspruch 10,
**dadurch gekennzeichnet, dass**
die Tiefdruckform (10) als Walze oder Walzenmantel ausgestaltet ist.

12. Verwendung einer Druckvorrichtung zum Aufdrucken einer Schablonenschicht auf eine Tiefdruckform,
wobei das Aufdrucken durch Aufjetten von Schablonenmaterial in Form von Tröpfchen durchgeführt wird, **dadurch gekennzeichnet, dass** ein Tröpfchenvolumen von zumindest teilweise weniger als 10 pl verwendet wird.

13. Verwendung nach Anspruch 12,
**dadurch gekennzeichnet, dass**
die Schablonenschicht auf eine Oberfläche der Tiefdruckform aufgedruckt wird, welche Nickel oder eine Nickelverbindung aufweist.

## Claims

1. A method for structuring a surface of an intaglio printing plate,
- in which a stencil layer is printed onto the surface of the intaglio printing plate,
- in which the printing is carried out by spraying stencil material in the form of droplets,
- in which the stencil layer is contoured during printing, so that the stencil layer has recesses, and
- in which a chemical treatment of the surface of the intaglio printing plate is performed after the printing of the stencil layer, in which material is applied to the surface of the intaglio printing plate or is removed from the surface of the intaglio printing plate,
**characterised in that**
at least partially a droplet volume of less than 10 pl is used.

2. The method according to claim 1,
**characterised in that**
the applied or removed material of the surface of the intaglio printing plate contains nickel or nickel compounds.

3. The method according to claim 1 or 2,
**characterised in that**
the stencil layer is printed, and, after the printing, a chemical treatment comprising nickel-plating is performed.

4. The method according to claim 3,
**characterised in that**
an electrically insulating material is used as the stencil material, and electrochemical nickel-plating of the surface is performed.

5. The method according to claim 1 or 2, **characterised in that**
- at least part of the surface has nickel-plating before the printing of the stencil layer,
- an etch-resistant material is used as the stencil material, and
- a chemical treatment comprising removal of surface material by etching is performed.

6. The method according to any one of claims 1 to 5,
**characterised in that**
a wax, a UV-curable ink or a combination thereof is used as the stencil material.

7. The method according to any one of claims 1 to 6,
**characterised in that**
at least two stencil layers are printed.

8. The method according to any one of claims 1 to 7,
**characterised in that**
at least two different stencil materials are used to print the at least two stencil layers.

9. The method according to any one of claims 1 to 8,
**characterised in that**
at least some of the stencil layer is printed using a hot melt method.

10. An intaglio printing plate (10), having a surface (2) which has indentations (4; 4a, 4b, 4c) and bars (6; 6a, 6b, 6c) for receiving ink in an intaglio printing process,
**characterised in that**
at least some of the surface (2) has been structured using a method according to claims 1 to 9, and at least some of the bars (6; 6a, 6b, 6c) have a minimum dimension of less than 20 µm.

11. The intaglio printing plate according to Claim 10,
**characterised in that**
the intaglio printing plate (10) is in the form of a roll or roll sleeve.

12. Use of a printing device for printing a stencil layer onto an intaglio printing plate, in which the printing is carried out by spraying stencil material in the form of droplets,
**characterised in that**
at least partially a droplet volume of less than 10 pl is used.

13. Use according to claim 12,
**characterised in that**
the stencil layer is printed onto a surface of the intaglio printing plate which contains nickel or a nickel compound.

## Revendications

1. Procédé de structuration d'une surface de plaque d'héliogravure
- pour lequel une couche écran est surimprimée sur la surface de la plaque d'héliogravure
- la surimpression est exécutée par projection du matériau d'écran sous la forme de gouttelettes,
- la couche écran est profilée lors de la surimpression de telle sorte que la couche écran comporte des évidements, et
- pour lequel il est procédé à un traitement chimique de la surface de la plaque d'héliogravure après la surimpression de la couche écran, un produit étant appliqué à la surface de la plaque d'héliogravure ou enlevé de la surface de la plaque d'héliogravure, **caractérisé en ce qu'**un volume de gouttelettes de moins de 10 pl est utilisé au moins en partie.

2. Procédé selon la revendication 1
**caractérisé en ce que**
le produit appliqué ou enlevé de la surface de la plaque d'héliogravure comporte du nickel ou un composé à base de nickel.

3. Procédé selon la revendication 1 ou 2,
**caractérisé en ce que**
la couche écran est surimprimée et que l'on procède après la surimpression à un traitement chimique comprenant un nickelage.

4. Procédé selon la revendication 3,
**caractérisé en ce**
**qu'**un matériau électro-isolant est utilisé comme matériau écran et qu'il est procédé à un nickelage électrochimique de la surface.

5. Procédé selon la revendication 1 ou 2, **caractérisé en ce que**
- la surface comporte au moins en partie un nickelage avant la surimpression de la couche écran,
- un matériau résistant à l'attaque chimique est utilisé comme matériau écran, et
- que l'on procède à un traitement chimique comprenant un raclage de surface par la technique d'attaque chimique.

6. Procédé selon l'une quelconque des revendications 1 à 5,
**caractérisé en ce**
**qu'**une cire, une encre durcissable aux UV ou une combinaison de ceux-ci est utilisée comme matériau écran.

7. Procédé selon l'une quelconque des revendications 1 à 6,
**caractérisé en ce**
**qu'**au moins deux couches écrans sont surimprimées.

8. Procédé selon l'une quelconque des revendications 1 à 7,
**caractérisé en ce que**
qu'au moins deux matériaux écrans différents sont utilisés pour surimprimer au moins deux couches écrans.

9. Procédé selon l'une quelconque des revendications 1 à 8,
**caractérisé en ce que**
la couche écran est surimprimée au moins en partie dans un procédé thermofusible.

10. Plaque d'héliogravure (10) avec une surface (2), laquelle comporte des alvéoles (4,4a,4b,4c) et des segments (6,6a,6b,6c) destinés à recevoir de l'encre dans un procédé d'héliogravure,
**caractérisée en ce que**
la surface (2) a été structurée au moins en partie avec un procédé selon l'une quelconque des revendications 1 à 9, et
les segments (6,6a,6b,6c) comportent au moins en partie une dimension minimale de moins de 20 µm.

11. Plaque d'héliogravure selon la revendication 10,
**caractérisée en ce que**
la plaque d'héliogravure (10) est structurée sous la forme d'un cylindre ou d'une enveloppe de cylindre.

12. Utilisation d'un dispositif d'impression pour surimprimer une couche écran sur une plaque d'héliogravure, la surimpression étant exécutée par projection de matériau écran sous la forme de gouttelettes, **caractérisée en ce qu'**un volume de gouttelettes inférieur à 10 pl est utilisé au moins en partie.

13. Utilisation selon la revendication 12,
**caractérisée en ce que**
la couche écran est surimprimée sur une surface de la plaque d'héliogravure, laquelle comporte du nickel ou un composé à base de nickel.
